# EUROPEAN PATENT SPECIFICATION

(11) **EP 1 942 525 B1**
(45) Date of publication and mention of the grant of the patent: **15.11.2017**
(21) Application number: 07025011.3
(22) Date of filing: 21.12.2007
(51) Int. Cl.: H01L 27/12, G02F 1/1362, G09G 3/36, G11C 19/18, G11C 19/28

(54) **Gate driving circuit, liquid crystal display having the same , and manufacturing method for thin film transistor substrate**
Gate-Treiberschaltung, Flüssigkristallanzeigevorrichtung damit und Herstellungsverfahren für ein Dünnfilmtransistorsubstrat
Circuit de commande de porte, affichage à cristaux liquides le comportant, et procédé de fabrication de substrat de transistor à couche mince

(30) Priority: 05.01.2007 KR 20070001536
(43) Date of publication of application: 09.07.2008
(73) Proprietor: Samsung Display Co., Ltd., Gyeonggi-do (KR)
(72) Inventor: Kim, Jeong-II, Seocho-gu, Seoul (KR); Baek, Seung-Soo, Gwanak-gu, Seoul (KR); Lee, Chang-Soo, Uijeongbu-si, Gyeonggi-do (KR); Lee, Min-Cheol, Dongjak-gu, Seoul (KR)
(74) Representative: Dr. Weitzel & Partner

(56) References cited:
- EP-A2- 1 213 763
- WO-A1-97/05654
- KR-A- 20060 091 465
- US-A1- 2004 066 637

## Description

### CROSS-REFERENCE TO RELATED APPLICATION

This application claims the benefit of priority to Korean Patent Application No. 10-2007-0001536, filed on January 5, 2007 in the Korean Intellectual Property Office, published as KR20070001536-A.

### BACKGROUND OF THE INVENTION

### 1. Field of the Invention

The present invention relates to a liquid crystal display (LCD) and more specifically, to a gate driving circuit, a liquid crystal display having the same, and a method of manufacturing a thin film transistor substrate, capable of preventing damage by an electrostatic discharge in a fabrication process of a liquid crystal display panel.

### 2. Description of the Related Art

Generally, a liquid crystal display comprises a liquid crystal display panel for displaying an image. The liquid crystal display panel includes a display area displaying an image and a peripheral area adjacent to the display area. The display area consists of a plurality of gate lines, a plurality of data lines, and a plurality of pixels. Each of the pixels consists of a thin film transistor and a liquid crystal capacitor. Meanwhile, the peripheral area consists of a gate driving circuit supplying a gate driving signal to gate lines and a data driving circuit supplying a data driving signal to data lines.

The gate driving circuit is simultaneously formed in the peripheral area of the liquid crystal display panel by the same fabrication process as that of the thin film transistor. The gate driving circuit includes a pull-up transistor supplying the gate driving signal to the gate line, a capacitor boot-strapping a pulse for turning on the pull-up transistor, a holding transistor connected to an output terminal of the pull-up transistor to maintain a voltage level of the gate driving signal, and a switching transistor turned off through the gate driving signal from the pull-up transistor to turn on the holding transistor. In this way, the gate driving circuit is connected to the pixel area of the liquid crystal display through the output terminal of the pull-up transistor and the gate line. An example of such a driving circuit is provided in Korean patent application published under KR20060091465-A. Meanwhile, in a fabrication process of the liquid crystal display, the gate line and a gate electrode of the gate driving circuit are simultaneously formed to form a gate metal pattern group. After the gate metal pattern group is formed, an electrostatic discharge generated in the pixel area is introduced into a gate pad formed at one end of the gate line through the gate line. As a result, the electrostatic discharge is introduced into the switching transistor of the gate driving circuit connected to the gate pad. At this time, the electrostatic discharge introduced into the switching transistor causes damage to the metal pattern of the gate driving circuit at its dense portion.

### SUMMARY OF THE INVENTION

The present invention provides a gate driving circuit, a liquid crystal display having the same, and a method of manufacturing a thin film transistor substrate capable of preventing damages by an electrostatic discharge introduced from a display area of a liquid crystal display panel in a fabrication process of the liquid crystal display panel.
It is the objective of the invention to provide a gate driving circuit as per the preamble of claim 1 which does not have the above described disadvantages.The set objective will be achieved by a device as defined in claim 1 and by a method as defined in claim 9.

### BRIEF DESCRIPTION OF THE DRAWINGS

The features of the present invention will become more apparent in light of the following description and the attached drawings, in which:
FIG. 1 is a block diagram showing an embodiment of the present invention;
FIG. 2 is a block diagram showing the first and second gate driving circuits shown in FIG. 1;
FIG. 3 is a circuit of the first stage shown in FIG. 2;
FIG. 4 is a plan view of the structure of the first stage shown in FIG. 3;
FIGS. 5A and 5B are cross-sectional views taken along line I-I' in FIG. 4;
FIG. 6 is a plan view of an exemplary structure of a gate metal pattern of the first stage shown in FIG. 4;
FIG. 7A is a plan view of a thin film transistor substrate according to an embodiment of the present invention;
FIG. 7B is a cross-sectional view taken along line I-I' of FIG. 7A;
FIG. 7C is a cross-sectional view taken along line II-II' of FIG. 7A;
FIG. 8A is a plan view showing a step in the method of manufacturing the thin film transistor substrate according to an embodiment of the present invention; and.
FIGS. 8B to 8P are cross-sectional views showing steps in a method of manufacturing the thin film transistor substrate according to an embodiment of the present invention.

### DETAILED DESCRIPTION OF THE EMBODIMENTS

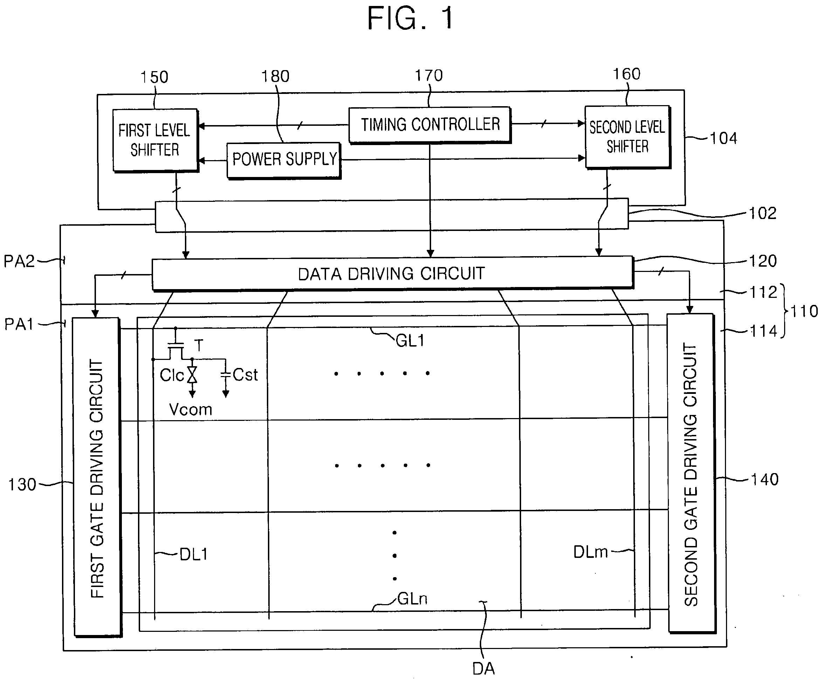

The present invention is described more fully hereinafter with reference to FIGS. 1 to 8P, in which exemplary embodiments of the invention are shown.

FIG. 1 is a block diagram of a liquid crystal display according to an embodiment of the present invention,

As shown in FIG. 1, the liquid crystal display comprises a liquid crystal display panel 110, a data driving circuit 120, gate driving circuits 130 and 140, level shifters 150 and 160, a timing controller 170, and a power supply 180.

The liquid crystal display panel 110 comprises a TFT substrate 112 and a color filter substrate 114 combined with each other. The liquid crystal display panel 110 includes a liquid crystal layer (not shown) which is driven by an electric field generated between the TFT substrate 112 and the color filter substrate 114 to control an amount of light passing through the liquid crystal layer.

The color filter substrate 114 comprises a black matrix formed in a matrix on a transplant insulating substrate such as glass, red, green, and blue color filters formed in the area defined by the black matrix, and a common electrode applying a common voltage to the liquid crystal.

The TFT 112 includes a display area DA and first and second peripheral areas PA1 and PA2. The display area DA includes gate lines GL1, ..., GLn, data lines DL1, ..., DLm, and a plurality of pixels arranged in a matrix in which the gate lines and the data lines are connected to each other. The first peripheral area PA1 includes gate driving circuits 130 and 140 driving the gate lines GL1, ..., GLn. The second peripheral area PA2 includes a data driving circuit 120 driving the data lines DL1, ..., DLm. Herein, the first peripheral area PA1 indicates an area adjacent to one end of the gate lines GL1, ..., GLn, and the second peripheral area PA2 indicates an area adjacent to one end of the data lines DL1, ..., DLm.

The pixel area includes a TFT T connected to the gate lines GL1, ..., GLn and the data lines DL1, ..., DLm, a liquid crystal capacitor Clc connected to the TFT T, and a storage capacitor Cst. A gate electrode and a source electrode of the TFT T are connected to the gate lines GL1, ..., GLn and the data lines DL1, ..., DLm, respectively, and a drain electrode of the TFT T is connected to the liquid crystal capacitor Clc and the storage capacitor Cst.

The liquid crystal capacitor Clc is formed by a pixel electrode (not shown) formed on the TFT substrate 112, a common electrode (not shown) formed on the color filter substrate 114, and a liquid crystal layer disposed between the pixel electrode and the common electrode. Further, the storage capacitor Cst is formed by the pixel electrode, a storage electrode line (not shown) formed on the TFT substrate 112 to face the pixel electrode, and an insulating layer (not shown) disposed between the pixel electrode and the storage electrode line.

The gate driving circuits 130 and 140 are integrately formed at least at one end of the gate lines GL1, ..., GLn in the first peripheral area PA1 of the liquid crystal display panel 110. Herein, the gate driving circuits 130 and 140 are integrated at both ends of the gate lines GL1, ..., GLn and formed as the first and second gate driving circuits 130 and 140. More specifically, the first and second gate driving circuits 130, and 140 are simultaneously formed in the first peripheral area PA1 along with the TFT T with the same a fabrication process as that of the TFT T formed in the display area DA. Outputs of the first and second gate driving circuits 130 and 140 are connected to each of the gate lines GL1, ...., GLn. The first and second gate driving circuits 130 and 140 sequentially supply a gate driving signal at both ends of the gate lines GL1, ..., GLn to drive the gate lines GL1, ..., GLn.

The data driving circuit 120 receives a data control signal and data from a timing controller 170, and selects an analog driving voltage corresponding to the data to supply the gray-scale voltage to the data lines DL1, ..., DLm. The data driving circuit 120 is formed with an integrated chip, and mounted in the second peripheral area PA2 of the TFT substrate 112. The data driving circuit 120 is connected to the timing controller 170 and the power supply 180 through a flexible printed circuit board 102 connected to the second peripheral area PA2. Herein, the data driving circuit 120 is not limited to be formed in the second peripheral area PA2 of the TFT substrate 112, but may be formed with a tape carrier package (TCP) method.

The level shifters 150 and 160 receive a gate control signal from the timing controller 170 and a driving voltage from the power supply 180 to generate a signal driving the first and second driving circuits 130 and 140, and then supply the signal to the first and second gate driving circuits 130 and 140. Herein, the level shifters 150 and 160 are formed as first and second level shifters 150 and 160 supplying a driving signal to the first and second driving circuits 130 and 140, respectively.

The timing controller 170 receives data and an input control signal from an external source to generate gate control signals and a data control signals, and then supply the gate control signals and the data control signals to the first and second level shifters 150 and 160 and the data driving circuit 120. Herein, the data indicates RGB image signals and the input control signal includes a vertical synchronizing signal VSYNC, a horizontal synchronizing signal HSYNC, a main clock MCLK, and a data enable signal DE.

The power supply 180 generates an analog driving voltage AVDD, a common voltage VCOM, and a gate driving voltage using a source voltage received from an external source. The power supply 180 supplies the data driving circuit 120 with the analog driving voltage AVDD, supplies the common electrode of the liquid crystal display panel 110 with the common voltage VCOM, and supplies the level shifters 150 and 160 with the gate driving voltage.

The timing controller 170, the first and second level shifters 150 and 160, and the power supply 180 are mounted on the printed circuit substrate 104. The printed circuit substrate 104 is connected to the second peripheral area PA2 of the TFT substrate 112 through the flexible circuit substrate 102. The gate driving circuits 130 and 140 formed on the liquid crystal display panel 110 are connected to the timing controller 170 and the power supply 180 through the data driving circuit 120 or the flexible circuit substrate 102.

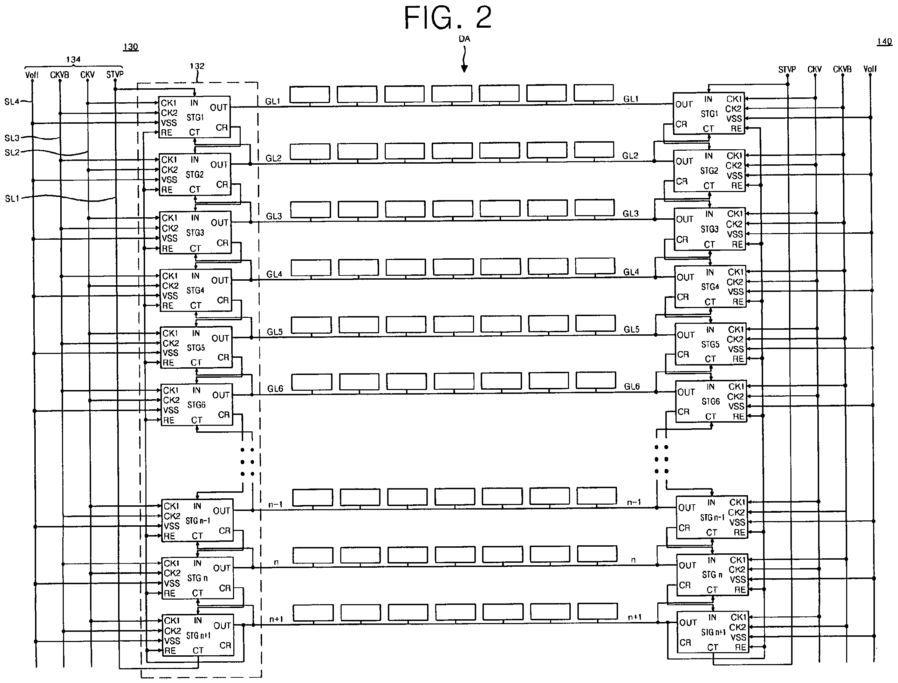

FIG. 2 is a block diagram of the first and second gate driving circuits shown in FIG. 1.

As shown in FIG. 2, the first and second gate driving circuits are positioned adjacent to opposite sides of the display area DA to drive the gate lines GL1, ..., GLn which terminate on both opposite sides.

The first and second gate driving circuits 130 and 140 have a structure symmetric to each other with respect to the gate lines GL1, ..., GLn. Each of the first and second gate driving circuits 130 and 140 includes a wiring portion 134 receiving and delivering signals from the data driving circuit 120 and a circuit portion 132 sequentially outputting the gate driving signal in response to the signals.

The circuit portion 132 is comprised of a shift register having a plurality of stages STG1, ..., STG(n+1) connected to one another. Each of the first to the (n+1)th stages STG1,..., STG(n+1) connected to one another in the circuit portion 132 is electrically connected to sequentially output the gate driving signal. The (n+1)th stage STG(n+1) indicates a dummy stage. Herein, n is an even number.

Each of the stages STG1,..., STG(n+1) includes first and second clock terminals CK1 and CK2, an input terminal IN, a control terminal CT, an output terminal OUT, a reset terminal RE, a carry terminal CR, and a ground voltage terminal VSS.

In odd-numbered stages STG1, STG3, ..., STG(n+1) among the stages STG1, ..., STG(n+1), the first clock terminal CK1 receives a gate clock pulse CKV and the second clock terminal CK2 receives a gate clock bar pulse CKVB. In even-numbered stages STG2, STG4, ..., STGn among the stages STG1, ..., STG(n+1), the first clock terminal CK1 receives a gate clock bar pulse CKVB and the second clock terminal CK2 receives a gate clock pulse CKV.

The input terminal IN of each of the stages STG1, ..., STG(n+1) is connected to the carry terminal CR of a previous stage to receive a carry signal of the previous stage, and the control terminal CT is connected to the output terminal OUT of a next stage to receive the output signal of the next stage. The input terminal IN of the first stage STG1 receives a start pulse STVP because there exist no a previous stage. The carry signal outputted from the carry terminal CR drives the next stage.

It is preferable that the control terminal CT of the dummy stage STG(n+1) supplying the control terminal CT of the nth stage STGn with a carry signal receives a start pulse STVP. The ground voltage terminal VSS of the stages STG1, ..., STG(n+1) receives the ground voltage VOFF and the reset terminal RE receives the output signal of (n+1)th stage STG(n+1).

Further, the output terminals OUT of the odd-numbered stages STG1, STG3, ..., STG(n+1) among the stages STG1, ..., STG(n+1) output the gate clock pulse CKV as a gate driving signal and the carry terminals CR thereof output the gate clock pulse CKV as a carry signal. The output terminals OUT of the even-numbered stages STG2, STG4, ..., STGn among the stages STG1, ..., STG(n+1) output the gate clock bar pulse CKVB as a gate driving signal and the carry terminals CR thereof output the gate clock bar pulse CKVB as a carry signal. In other words, the first gate driving circuit 130 outputs the gate driving signals by synchronizing the gate clock pulse CKV with the odd-numbered stages STG1, STG3, ..., STG(n+1), and synchronizing the gate clock bar pulse CKVB with the even-numbered stages STG2, STG4, ..., STGn.

The output terminals OUT of the stages STG1, ..., STGn of the first gate driving circuit 130 are connected to the gate lines GL1, ..., GLn formed in the display area DA, respectively to sequentially supply the gate driving signal to the gate lines GL1, ..., GLn to sequentially drive the gate lines GL1, ..., GLn.

The wiring portion 134 is formed adjacent to the circuit portion 132. The wiring portion 134 includes a start pulse wiring SL1, a gate clock pulse wiring SL2, a gate clock bar pulse wiring SL3, a ground voltage wiring SL4, and a reset wiring SL5, which are extended parallel to one another.

The start pulse wiring SL1 receives the start pulse STVP from the first level shifter 150 and delivers the start pulse STVP to the input terminal of the first stage STG1 and the control terminal CT of the (n+1)th stage STG(n+1).

The gate clock pulse wiring SL2 receives the gate clock pulse CKV from the first level shifter 150 and delivers the gate clock pulse CKV to the first clock terminals CK1 of the odd-numbered stages STG1, STG3, ..., STG(n+1) and the second clock terminals CK2 of the even-numbered stages STG2, STG4, ..., STGn

The gate clock bar pulse wiring SL3 receives the gate clock bar pulse CKVB from the first level shifter 150 and delivers the gate clock bar pulse CKV to the second clock terminals CK2 of the odd-numbered stages STG1, STG3, ..., STG(n+1) and the first clock terminals CK1 of the even-numbered stages STG2, STG4, ..., STGn.

The ground voltage wiring SL4 receives the gate-off voltage VOFF from the power supply 180 and delivers the gateoff voltage VOFF to the ground voltage terminal VSS of the first to (n+1)th stages STG1, ..., STG(n+1).

The reset wiring SL5 supplies the reset terminal RE of the stages STG1, ..., STG(n+1) with the output signal of the output terminal OUT of the (n+1)th stage STG(n+1) as a reset signal REsig.

The second gate driving circuit 140 is symmetric to the first gate driving circuit 130 with respect to the gate lines GL1, ..., GLn. Accordingly, the second gate driving circuit 140 has the same configuration as that of the first gate driving circuit 130, and therefore the detailed description of the second gate driving circuit 140 will be omitted.

The gate driving circuits 130 and 140 are not limited to the first and second gate driving circuits 130 and 140 in accordance with the exemplary embodiment of the present invention, but may be formed with one gate driving circuit. Herein, the first gate driving circuit 130 is positioned adjacent to one end of the display area DA to drive the gate lines GL1, ..., GLn at one end of the display area DA. The second gate driving circuit 140 has the same configuration as that of the first gate driving circuit 130, and therefore the detailed description of the second gate driving circuit 140 is not required.

Further, the gate driving circuits 130 and 140 may be formed such that the odd-numbered stages STG1, STG3, ..., STG(n+1) of the first gate driving circuit 130 are formed at one end of the gate lines GL1, ..., GLn and the even-numbered stages STG2, STG4, ..., STGn of the second gate driving circuit 140 are formed at the other end of the gate lines GL1, ..., GLn. Then the odd-numbered stages STG1, STG3, ..., STG(n+1) and the even-numbered stages STG2, STG4, ..., STGn may be alternately driven. The second gate driving circuit 140 receives the gate clock pulse CKV outputted from the output terminal OUT of the first stage STG1 of the first gate driving circuit 130 through the input terminal IN of the second stage STG2 and the control terminal CT of the nth stage STGn instead of receiving the start pulse STVP at the first stage of the even-numbered stages STG2, STG4, ..., STGn. An operation of each of the odd-numbered stages STG1, STG3, ..., STG(n+1) and the even-numbered stages STG2, STG4, ..., STGn of the gate driving circuits 130 and 140 is the same as that of the first gate driving circuit 130, and therefore the detailed description thereof will be omitted.

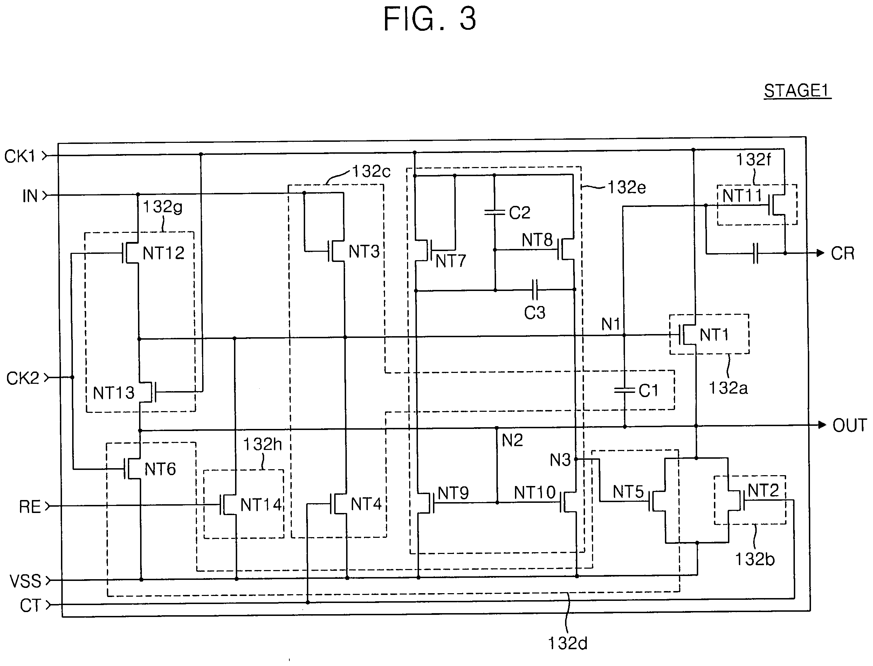

FIG. 3 is a circuit diagram for explaining the first stage shown in FIG. 2.

Herein, the first stage has the same configuration as each of the second to the (n+1)th stages, and therefore only configuration of the first stage will be described except for that of the second to the (n+1)th stages.

As shown in FIG. 3, the first stage includes a pull-up portion 132a, a pull-down portion 132b, a driving portion 132c, a holding portion 132d, a switching portion 132e, and a carry portion 132f.

The pull-up portion 132a pulls up the gate clock pulse CKV supplied through the first clock terminal CK1 to be output as the gate driving signal through the output terminal OUT. The pull-up portion 132a includes a first transistor NT1 with a gate electrode connected to a first node N1, a source electrode connected to the first clock terminal CK1, and a drain electrode connected to the output terminal OUT. The first transistor NT1 represents a pull-up transistor pulling up the gate clock pulse CKV. And the first transistor NT1 supplies the gate line of the pixel area with the gate driving signal through the output terminal OUT.

The pull-down portion 132b pulls down the gate driving signal pulled up in response to the carry signal from the second stage to the gate-off voltage VOFF supplied through the ground voltage terminal VSS. The pull-down portion 132b includes a second transistor NT2 with a gate electrode connected to a control terminal CT, a drain electrode connected to the output terminal OUT, and a source electrode connected to the ground voltage terminal VSS.

The driving portion 132c turns on the pull-up portion 132a in response to the start pulse STVP supplied through the input terminal IN and turns off in response to the carry signal of the second stage. For doing so, the driving portion 132c includes a buffer portion, a charging portion, and a discharging portion.

The buffer portion includes a third transistor NT3 with a gate electrode and a source electrode connected commonly to the input terminal IN and a source electrode connected to a first node N1. The charging portion includes a first capacitor C1 with a first electrode connected to the first node N1 and a second electrode connected to a second node N2. The discharging portion includes a fourth transistor NT4 with a gate electrode connected to the control terminal CT, a source electrode connected to the first node N1, and a drain electrode connected to the ground voltage terminal VSS.

When the input terminal IN receives the start pulse STVP, the third transistor NT3 is turned on responsive thereto, and the start pulse STVP is charged in the first capacitor C1. When a voltage higher than a threshold voltage of the first transistor NT1 is charged in the first capacitor C1, the first transistor NT1 is turned on to supply the gate clock pulse CKV supplied to the first clock terminal CK1 to the output terminal OUT. At this time, the potential of the first node N1 is bootstrapped by a variation of the potential of the second node N2 by a coupling of the first capacitor C1 in response to a variation of the potential of the second node N2. Therefore, the first transistor NT1 allows the first gate clock pulse CKV applied to the source electrode to be output through the output terminal OUT. Herein, the start pulse STVP uses the first transistor NT1 as a preparatory charging signal so as to generate the first gate driving signal. When the fourth transistor NT4 is turned on in response to the carry signal of the second stage inputted through the control terminal CT, the charges in the first capacitor C1 are discharged to the level of the gate-off voltage VOFF supplied through the ground voltage terminal VSS. The gate clock pulse CKV supplied to the output terminal OUT becomes the gate driving signal supplied to the gate line.

The holding portion 132d includes fifth and sixth transistors NT5 and NT6 holding the gate driving signal to the level of the gate-off voltage VOFF. The fifth transistor NT5 has a gate electrode connected to a third node N3, a source electrode connected to the second node N2, and a drain electrode connected to the ground voltage terminal VSS. The sixth transistor NT6 has a gate electrode connected to the second clock terminal CK2, a source electrode connected to the second node N2, and a drain electrode connected to the ground voltage terminal VSS.

The switching portion 132e includes seventh, eighth, ninth, and tenth transistors NT7, NT8, NT9, and NT10 and second and third capacitors C2 and C3, and controls driving of the holding portion 132d. The seventh transistor NT7 has gate and drain electrodes connected to the first clock terminal CK1 and a source electrode connected to the third node N3 through the third capacitor C3. The eighth transistor NT8 has a source electrode connected to the first clock terminal CK1, a gate electrode connected to the source electrode through the second capacitor C2, and a drain electrode connected to the third node N3 and the gate electrode through the third capacitor C3. The ninth transistor NT9 has a drain electrode connected to the source electrode of the seventh transistor NT7, a gate electrode connected to the second node N2, and a source electrode connected to the ground voltage terminal VSS. The tenth transistor NT10 has a source electrode connected to the third node N3, a gate electrode connected to the second node N2, and a drain electrode connected to the ground voltage terminal VSS.

When a high level of the gate clock pulse CKV is output as the gate driving signal to the output terminal OUT, the electric potential of the second node N2 becomes a high level. When the potential of the second node N2 becomes a high level, the ninth and tenth transistors NT9 and NT10 are switched to a turn-on state. At this time, although the seventh and eighth transistors NT7 and NT8 are switched to a turn-on state by the gate clock pulse CKV supplied to the first clock terminal CK1, the signal output from the seventh and eighth transistors NT7 and NT8 are discharged to the ground voltage VOFF through the ninth and tenth transistors NT9 and NT10. Accordingly, while a high level of the gate driving signal is output, the potential of the third node N3 maintains a low level and thus the fifth transistor NT5 maintains a turn-off state. The gate driving signal is discharged through the ground voltage terminal VSS in response to the carry signal of the second stage inputted through the control terminal CT, and the potential of the second node N2 gradually goes down to a low level. Accordingly, the ninth and tenth transistors NT9 and NT10 are switched to a turn-off state, and the potential of the third node N3 goes up to a high level by the signal outputted from the seventh and eighth transistors NT7 and NT8. As the potential of the third node N3 increases, the fifth transistor NT5 is turned on and the potential of the second node N2 is discharged to a ground voltage VOFF through the fifth transistor NT5.

In this state, when the sixth transistor NT6 is turned on by the gate clock bar pulse CKVB supplied to the second clock terminal CK2, the potential of the second node N2 is discharged through the ground voltage terminal VSS.

The fifth and sixth transistors NT5 and NT6 of the holding portion 132d hold the potential of the second node N2 to the ground voltage VOFF. The fifth transistor NT5 represents a holding transistor.

The switching portion 132e determines the timing when the fifth transistor NT5 is turned on. The fifth transistor NT5 of the switch portion 132e represents a switching transistor.

The carry portion 132f includes an eleventh transistor NT11 with a drain electrode connected to the first clock terminal CK1, a gate electrode connected to the first node N1, and a source electrode connected to the carry terminal CR. The eleventh transistor NT11 is turned on and supplies the gate clock pulse CKV inputted to the drain electrode to the carry terminal CR.

The first stage further includes a ripple preventing portion 132g and a reset portion 132h. The ripple preventing portion 132g prevents the gate driving signal maintained at the ground voltage VOFF from being rippled by a noise inputted through the input terminal IN. The ripple preventing portion 132g includes a twelfth transistor NT 12 and a thirteenth transistor NT13. The twelfth transistor NT 12 has a source electrode connected to the input terminal IN, a gate electrode connected to the second clock terminal CK2, and a drain electrode connected to the first node N1. The thirteen transistor NT13 has a drain electrode connected to the first node N1, a gate electrode connected to the first clock terminal CK1, and a source electrode connected to the second electrode N2.

The reset portion 132h includes a fourteenth transistor NT14 with a source electrode connected to the pull-up portion 132a through the first node N1, a gate electrode connected to the reset terminal RE, and a drain electrode connected to the ground voltage terminal VSS. The fourteenth transistor NT14 discharges a noise inputted through the input terminal IN in response to the reset signal which is an output signal of the (n+1)th stage inputted through the reset terminal RE. The reset portion 132h resets the first node N1 of each of the stages STG1, ..., STGn to the ground voltage VOFF by turning on the fourteenth transistor NT14 of each of the stages STG1, ..., STGn. Then, the stages STG1, ..., STG(n+1) of the circuit portion 132 can operate at an initial state again.

Meanwhile, the first transistor NT1 of the pull-up portion 132a and the tenth transistor NT10 of the switching portion 132e are connected through the second node N2. Herein, when an electrostatic discharge generated in the pixel area through the output terminal OUT connected to the gate line is introduced, the electrostatic discharge is also introduced into the first transistor NT1 and the tenth transistor NT10 through the second node N2. At this time, introducing the electrostatic discharge into the first transistor NT1 and the tenth transistor NT10 causes damages on a circuit. Therefore, an introduction of the electrostatic discharge should be prevented by forming the first transistor NT1 and the second node N2 such that they are not directly connected to each other at the gate level.

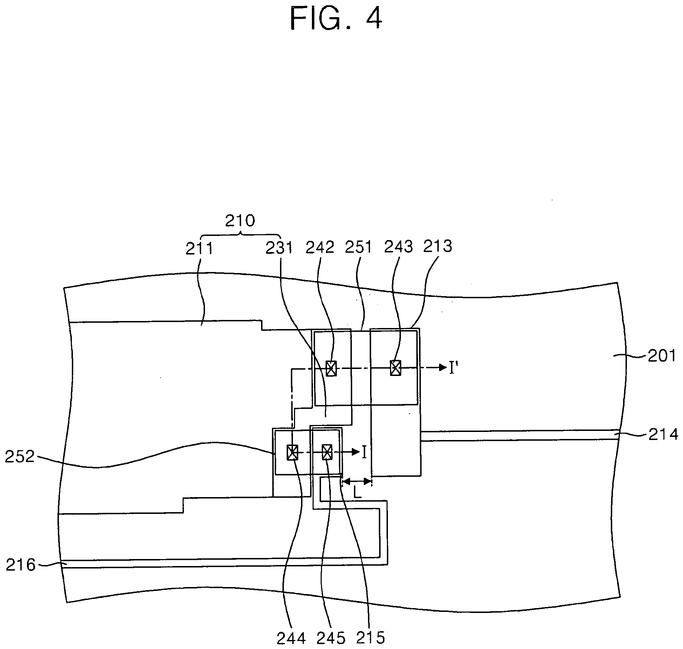

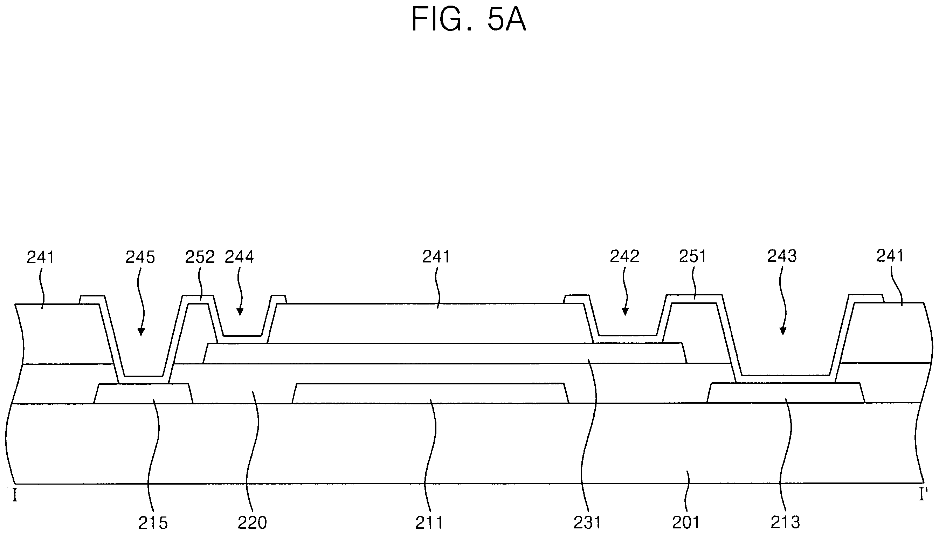

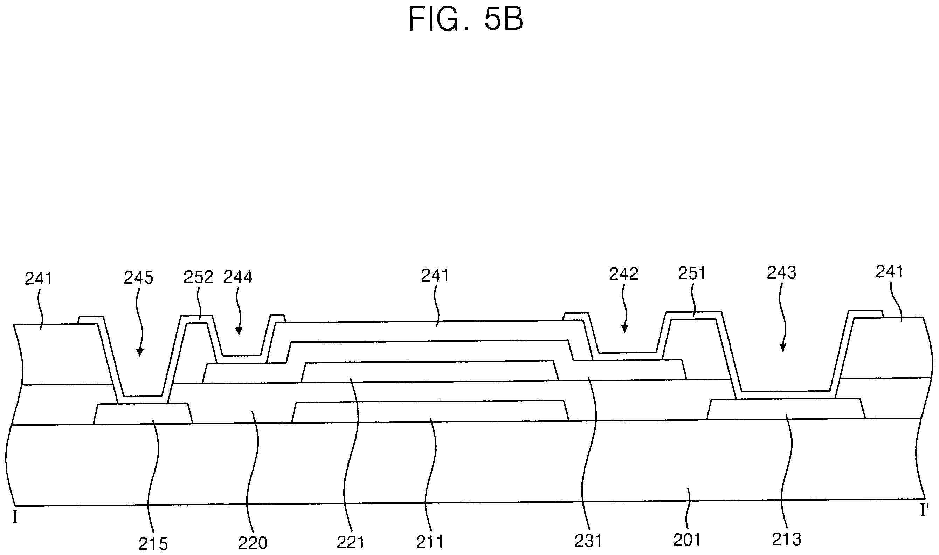

Herein, an exemplary structure of the first stage for preventing an introduction of the electrostatic discharge in accordance with an embodiment of the present invention is described below in detail with reference to FIGS. 4 and 5.

FIG. 4 is a plan view for explaining an exemplary structure of the first stage shown in FIG. 3, and FIGS. 5A and 5B are cross-sectional views taken along line I-I' shown in FIG. 4. Herein, a partial configuration of the first stage in accordance with an embodiment of the present invention is described.

As shown in FIG. 4, the first stage includes a capacitor 210 having a first electrode 211 and a second electrode 231, a gate pad 213 formed at one end of the gate line 214 and connected to the second electrode 231 through a first connecting electrode 251, and a contact portion 215 connected to the switching transistor through a signal supply line 216 and connected to the second electrode 231 through the second connecting electrode 252. Herein, the capacitor 210 corresponds to the first capacitor C1 shown in FIG. 3.

The capacitor 210 is formed by sequentially depositing the first electrode 211, an insulating layer 220 functioning as a dielectric substance, and the second electrode 231. The capacitor 210 is connected to the gate pad 213 to receive the gate driving signal outputted from the pull-up transistor and supply the gate driving signal to the gate line 214. The capacitor 210 is connected to the contact portion 215 connected to the switching transistor.

The capacitor 210, as shown in FIG. 5B, may further include an active layer 221 formed on the insulating layer 220. Herein, the active layer 221 functions as a dielectric substance like the insulating layer 220. The active layer 221 prevents a defect such as a short by a foreign substance between the first electrode 221 and the second electrode 231.

The gate pad 213 is formed at one end of the gate line 214 extending from the pixel area. Herein, the gate pad 213 is spaced apart from the first electrode 211 of the capacitor 210 by more than the width of the gate line 214. The gate pad 213 is connected to the second electrode 231 of the capacitor 210 through the first connecting electrode 251. The gate pad 213 supplies the gate line 214 with the gate driving signal.

The contact portion 215 is disposed between the capacitor 210 and the gate pad 213. The contact portion 215 is connected to the switching transistor through a signal wiring line 216. Herein, the contact portion 215 is spaced apart from the gate pad 213 by a distance L. It is preferable that L is formed to be more than the width of the gate line 214.

The first stage further includes a protecting layer 241 forming on the second electrode 231 and the insulating layer 220.

The first connecting electrode 251 is connected to the capacitor 210 and the gate pad 213 through the first and second contact holes 242 and 243 of the protecting layer 241. The second connecting electrode 252 is connected to the capacitor 210 and the contact portion 215 through third and fourth contact holes 244 and 245. By doing so, the gate pad 213 and the contact portion 215 are not connected through a conductive material on the same plane, and electrically connected using the capacitor 210 and the first and second connecting electrodes 251 and 252.

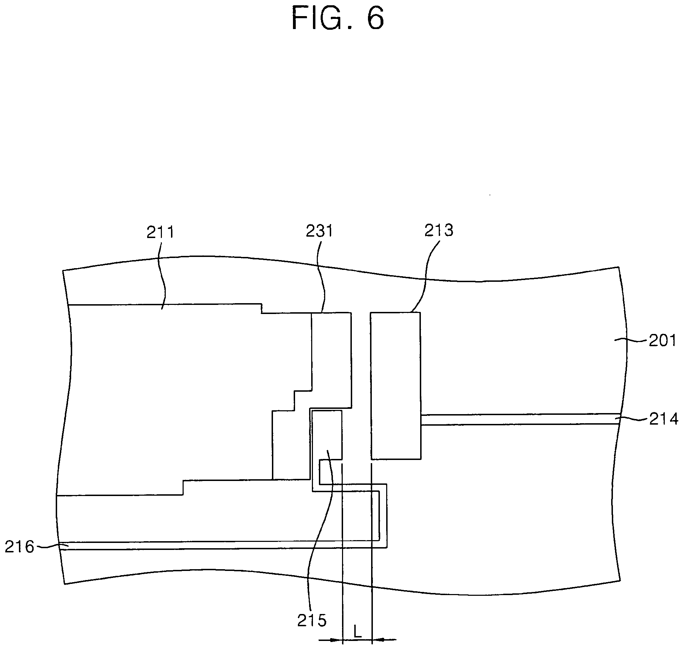

The distance L of the contact portion 215 is described below in detail with reference to FIG. 6.

FIG. 6 is a plan view of an exemplary structure of a gate metal pattern of the first stage shown in FIG. 4.

As shown in FIG. 6, the contact portion 215 is spaced apart from the gate pad 213 by the distance L. For example, the distance L is not limited, but it is preferable that the contact portion 215 is formed to be as large as possible considering the distance between the capacitor 210 and the gate pad 213 so that an electrostatic discharge generated in the pixel area and introduced into the gate pad 213 through the gate line 214 is not introduced into the contact portion 215. In this way, the contact portion 215 is not connected to the capacitor 210 and the gate pad 213 at the gate level, thereby preventing an introduction of the electrostatic discharge.

Meanwhile, the signal supply line 216 is connected to the contact portion 215 and the gate electrode of the switching transistor.

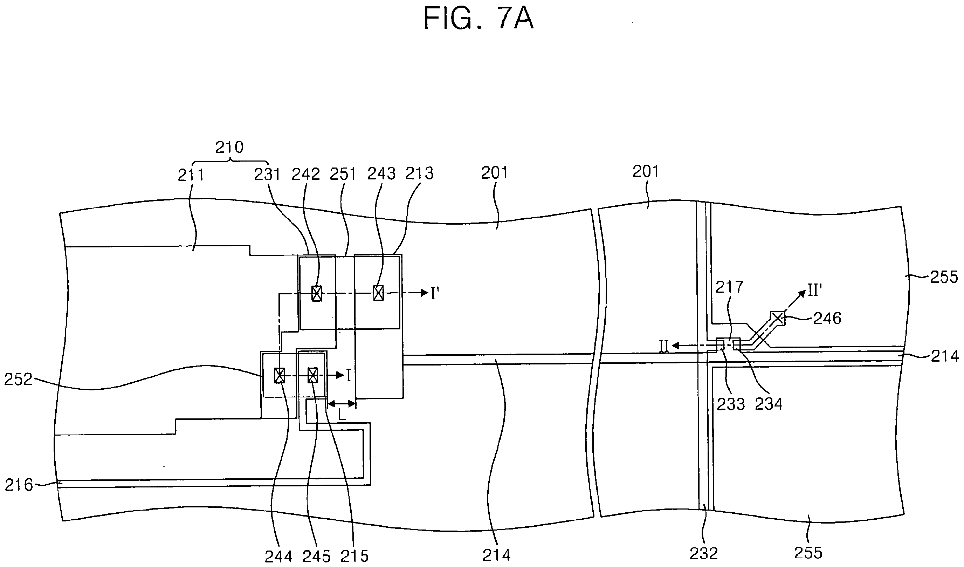

Herein, a method of manufacturing the TFT substrate in accordance with an embodiment of the present invention will now be described in detail with reference to FIGS. 7A to 8P.

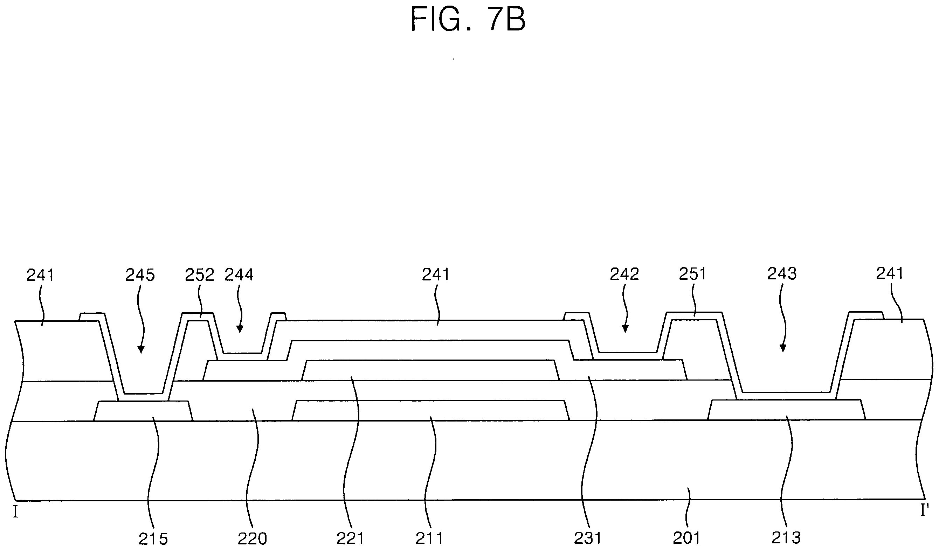

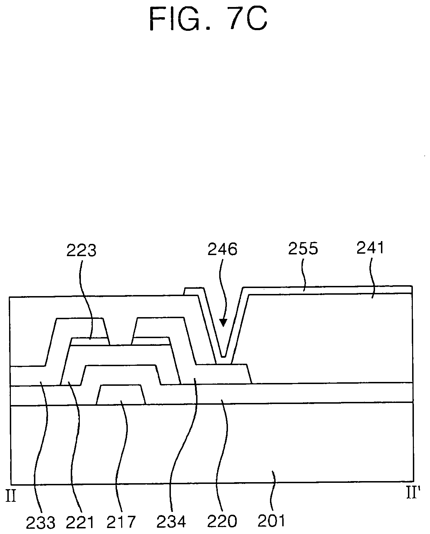

FIG. 7A is a plan view of the TFT substrate in accordance with an embodiment of the present invention, FIG. 7B is a cross-sectional view taken along line I-I' shown in FIG. 7A, and FIG. 7C is a cross-sectional view taken along line II-II' shown in FIG. 7A.

Referring to FIGS. 7A to 7C, a method of manufacturing the TFT substrate includes forming a gate metal pattern including the gate line 214, the gate pad 213, the first electrode 211, the contact portion 215, the signal supply line 216, and the gate electrode 217 on the substrate 201, forming the insulating layer 220 on the gate metal pattern, forming a semiconductor layer including the active layer 221 and an ohmic contact layer 223 on the insulating layer 220, forming a data metal pattern including the second electrode 231 and the source and drain electrodes 233 and 234 on a semiconductor layer, forming a protecting layer 241 on the data metal pattern and forming the contact holes 242, 243, 244, 245, and 246 so that the second electrode 231, the gate pad 213, the contact portion 213, and the drain electrode 234 are exposed, and forming the connecting electrodes 251 and 252 and the pixel electrode 255 which are connected to the second electrode 231, the gate pad 213, the contact portion 215, and the drain electrode 234 exposed through the contact holes 242, 243, 244, 245, and 246 on the protecting layer 241.

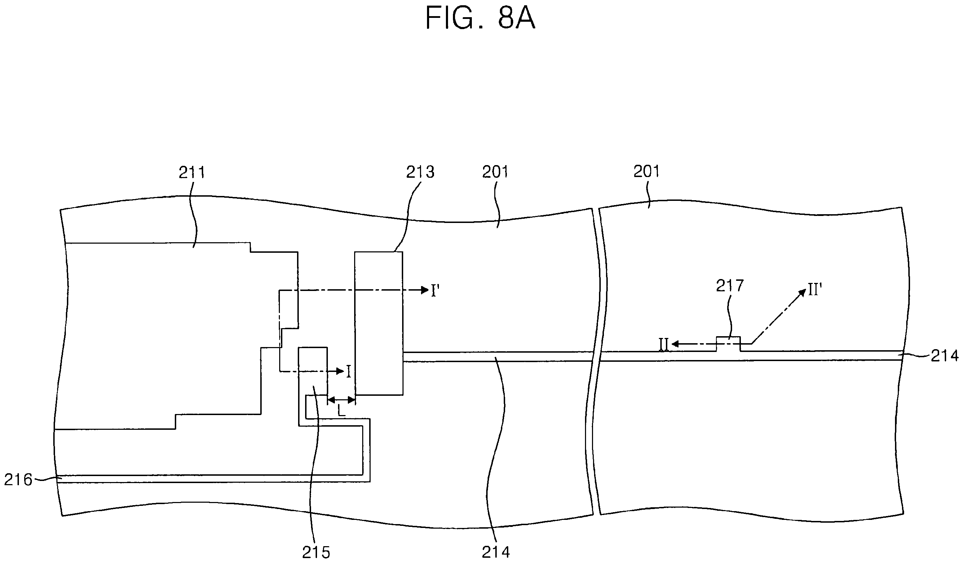

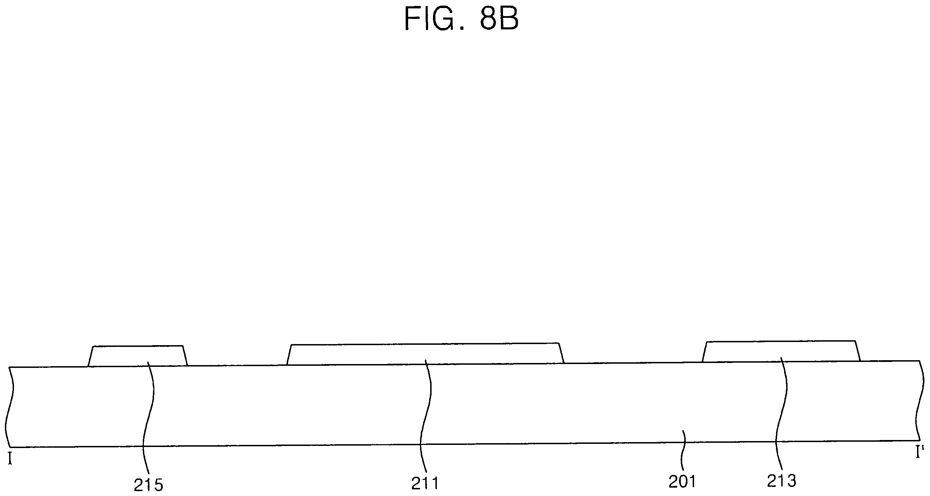

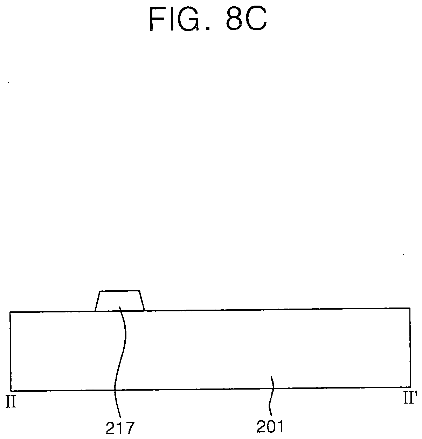

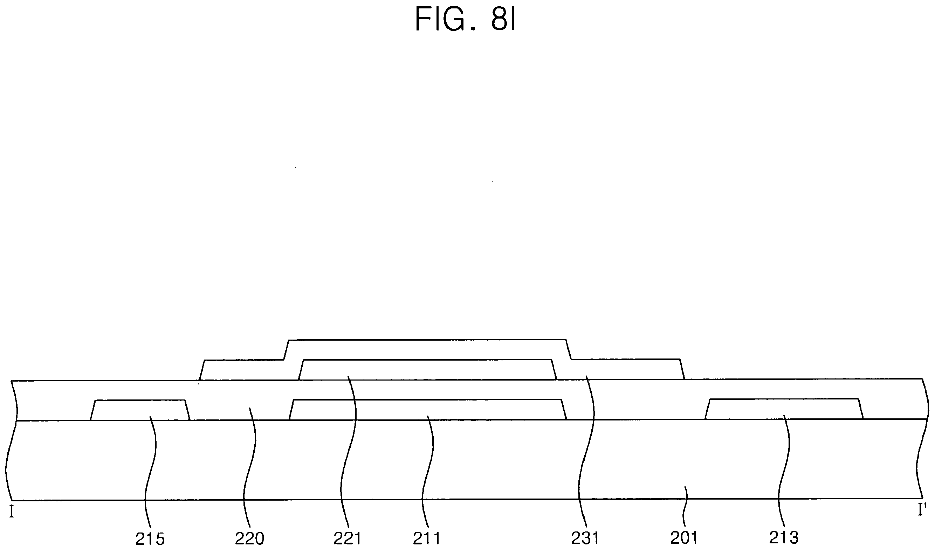

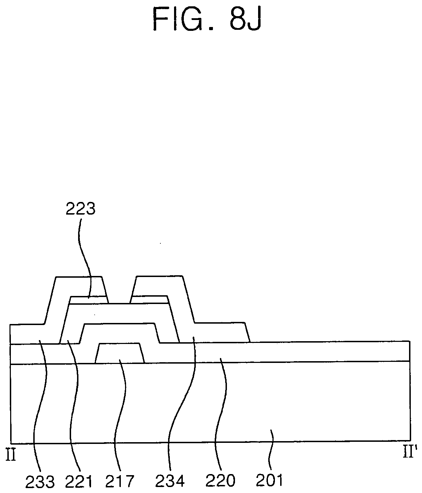

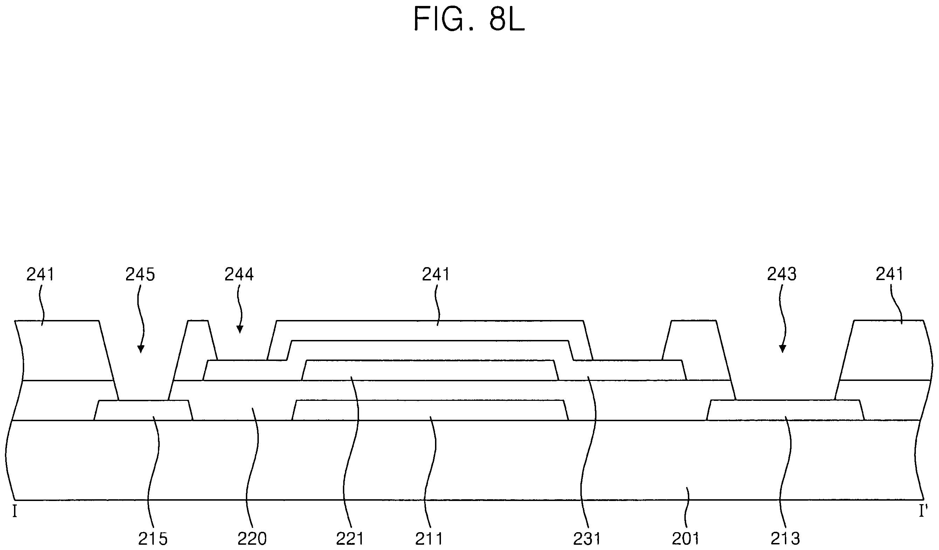

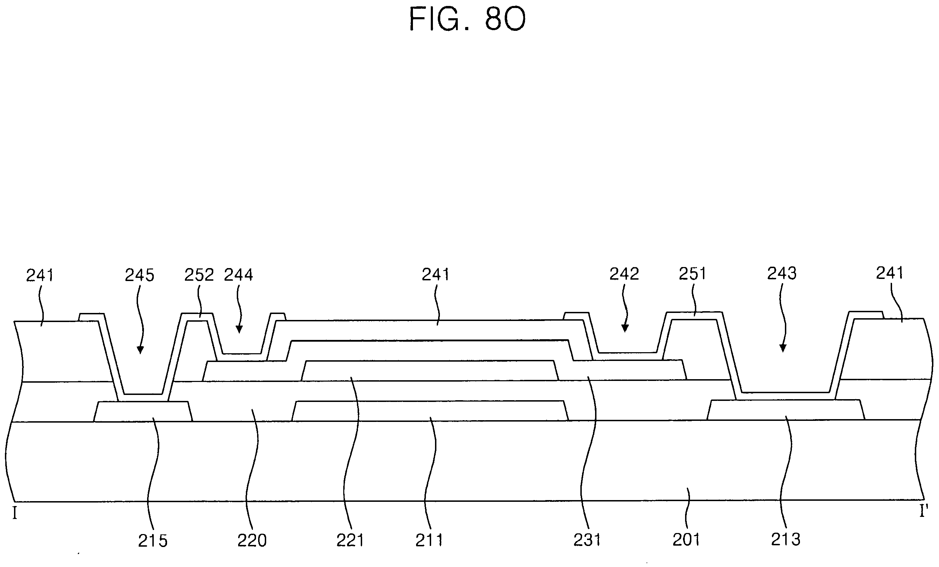

A method of manufacturing the TFT substrate will now be described in detail with reference to FIGS. 8A to 8P.

FIGS. 8A to 8P are a plan view and cross-sectional views for explaining a method of manufacturing the TFT substrate in accordance with an embodiment of the present invention.

As shown in FIGS. 8A to 8C, forming the gate metal layer including the gate line 214, the gate pad 213, the first electrode 211, the contact portion 215, the signal supply line 216, the gate electrode 217 on the substrate 201 is described below.

More specifically, the gate metal pattern including the gate line 214, the first electrode 211, the gate pad 213, the contact portion 215, and the signal supply line 216 constituting the gate driving circuit is formed. At this time, the gate metal pattern is formed by forming a gate metal layer by a deposition method such as a sputtering, etc. and then patterning the gate metal layer by photolithographic and etching processes. Herein, the substrate 201 generally uses a transparent insulating glass such as glass or plastic.

At the same time, the gate metal pattern including the gate line 214 and the gate electrode 217 constituting a pixel TFT are formed.

The gate line 214 is formed by extending from the pixel area to a gate driving circuit area, and the gate pad 213 is formed at end of the gate line 214. The first electrode 211 is spaced apart from one end of the gate pad 213 by a predetermined distance. The contact portion 215 is disposed between the gate pad 213 and the first electrode 211. The signal supply line 216 connects one end thereof to the contact portion 215 and the other end thereof to the gate electrode of the switching transistor. Further, the gate electrode 217 is connected to the gate line 214 and formed to be protruded at one end extending from the gate line 214.

Forming the gate metal pattern may cause an electrostatic discharge in the gate line 214 of the pixel area due to an electric property by fabrication circumstance. In this case, the electrostatic discharge moves to the gate pad 213 formed at one end of the gate line 214 through the gate line 214.

The contact portion 215 is spaced apart from the gate pad 213 by the distance L. It is preferable that the distance L represents more than the width of the gate line 214 so that the electrostatic discharge moved to the gate pad 213 is not introduced into the contact portion 215. Generally, considering that the width of the gate line 214 is formed to be about 4µm, it is preferable that the contact portion 215 is spaced apart from the gate pad 213 by more than 4µm but it is not limited thereto.

Further, it is preferable that the distance between the gate pad 213 and the first electrode 211 is more than the width of the gate line 214.

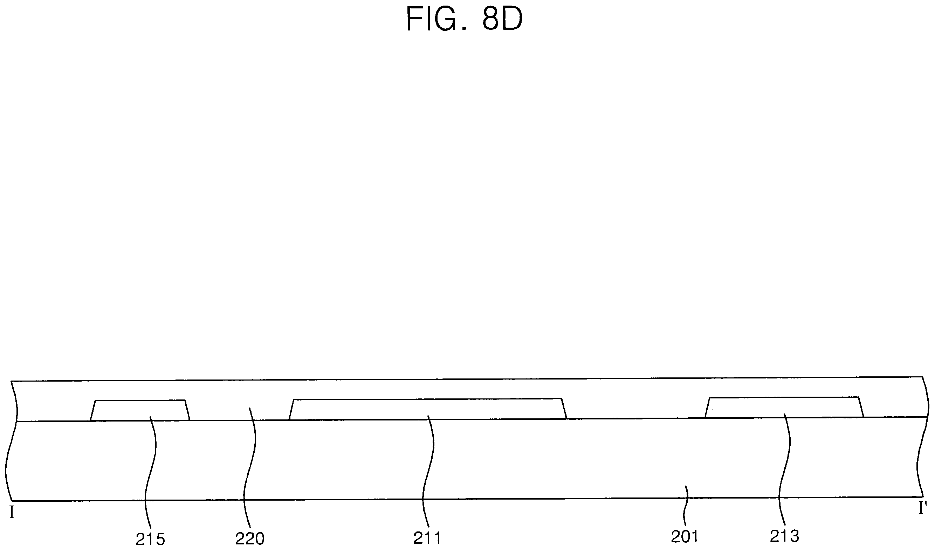

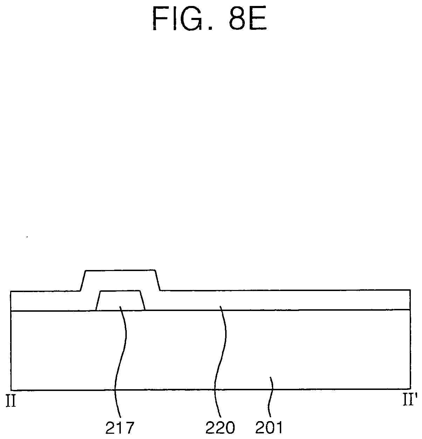

Next, as shown in FIGS. 8D and 8E, forming the insulating layer 220 on the substrate 201 having the gate metal pattern by a plasma enhanced chemical vapor deposition (PECVD) method, etc. will now be described. Herein, the insulating layer 220 is formed by depositing an insulating material such as SiOx or SiNx on the whole surface of the substrate 201. By doing so, the insulating layer 220 covers the gate metal pattern formed on the substrate 201 to insulate the gate metal pattern.

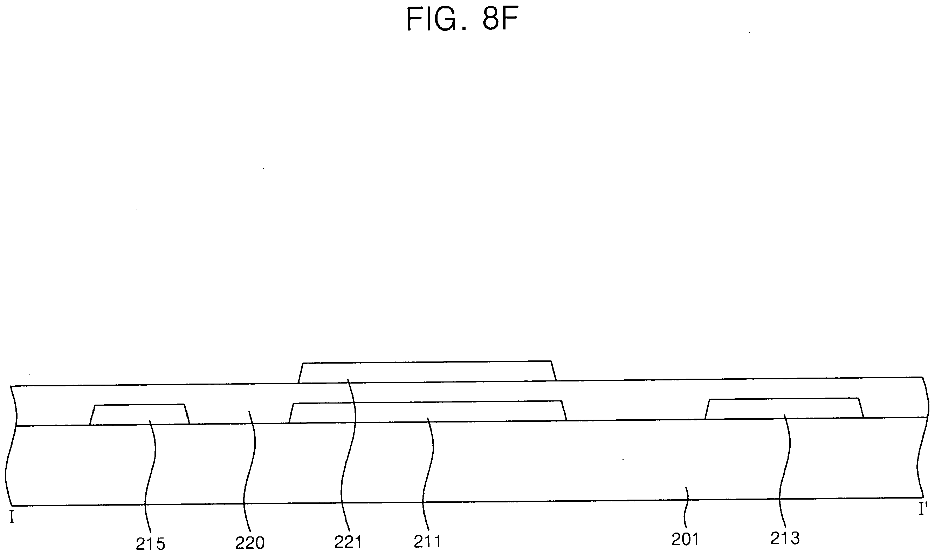

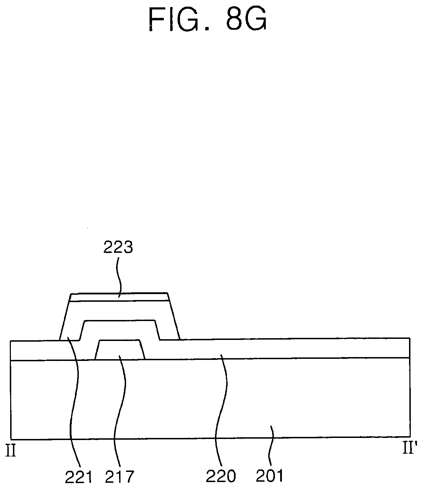

As shown in FIGS. 8F and 8G, forming the semiconductor layer including the active layer 221 and the ohmic contact layer 223 on the substrate 201 with the insulating layer 200 formed thereon will be described. At this time, the active layer 221 constituting the gate driving circuit is formed to overlap the first electrode 211.

The active layer 221 and the ohmic contact layer 223 are formed by being deposited with amorphous silicon and doped amorphous silicon, respectively, and then etched.

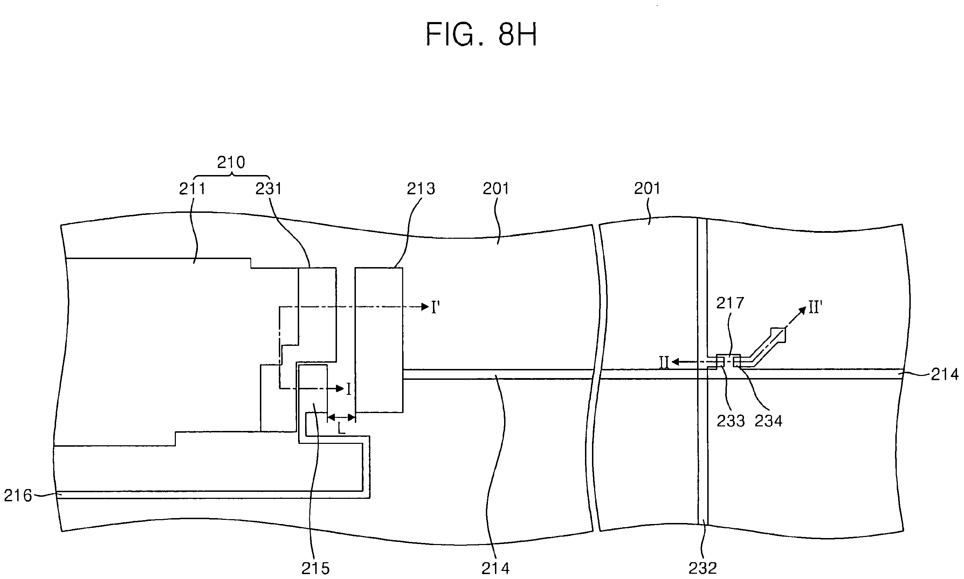

Next, as shown in FIGS. 8H to 8J, forming the data metal pattern including the second electrode 231, the data line 232, the source electrode 233, and the drain electrode 234 on the substrate 201 including the semiconductor layer will now be described.

More specifically, the data metal pattern is formed by forming the metal layer by a deposition method such as a sputtering method, etc. on the substrate 201 including the semiconductor layer, and then patterning the metal layer by photolithographic and etching processes. The second electrode 231 is patterned to overlap the first electrode 211. By doing so, the capacitor 210 with the insulating layer 220 disposed between the first and second electrodes 211 and 231 is formed.

At the same time, the pixel TFT is formed by forming the source electrode 233 and the drain electrode 234 on the ohmic contact layer 233 in the pixel area.

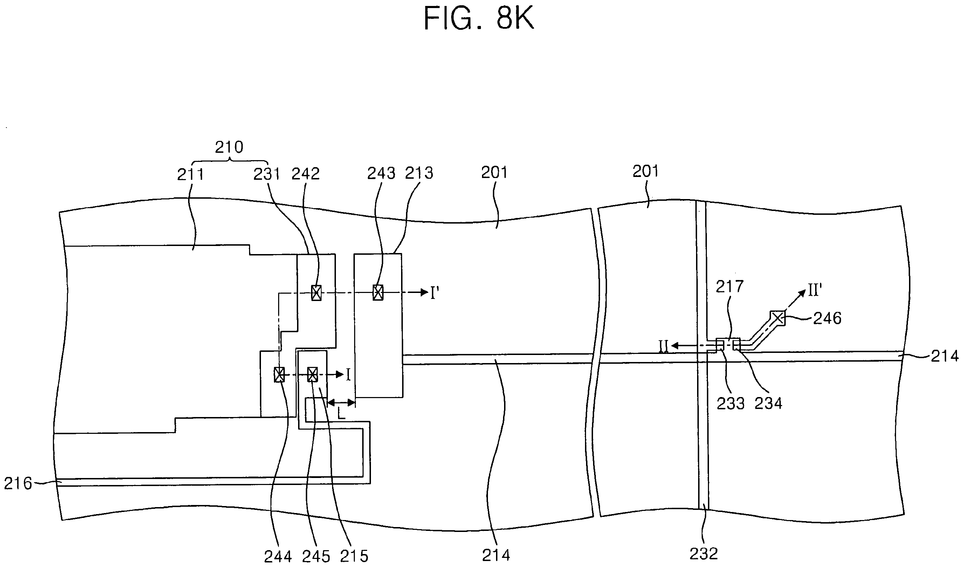

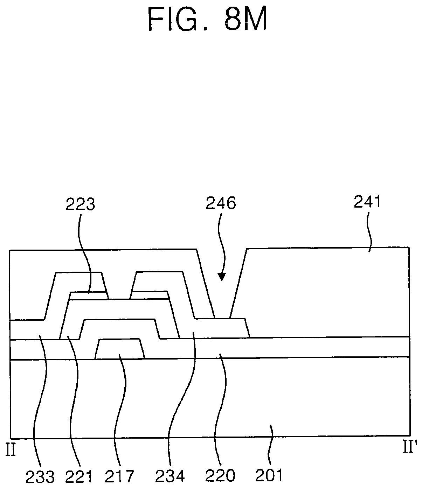

Next, as shown in FIGS. 8K and 8M, forming the protecting layer 241 and the first to the fifth contact holes 242, 243, 244, 245, and 246 on the substrate 201 including the data metal pattern will now be described.

The protecting layer 241 is formed by a deposition method such as PECVD or a spin coating method. The first, third, and fifth contact holes 242, 244, and 246 penetrating the protecting layer 241 and the second and fourth contact holes 243 and 245 penetrating the protecting layer 241 and the insulating layer 220 are formed by photolithographic and etching processes using a mask. The first to fifth contact holes 242, 243, 244, 245, and 246 expose parts of the second electrode 231, the gate pad 213, the contact portion 215, and the drain electrode 234.

The protecting layer 241 is formed of an inorganic material such as SiNx or SiOx for insulation, or an organic material such as acryl, polyimid, or benzocyclobutene (BCB).

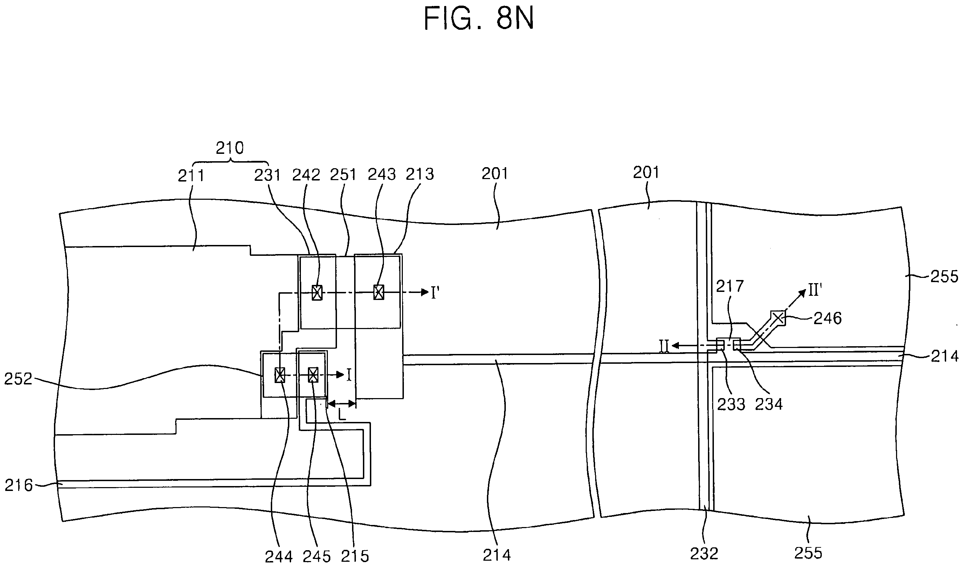

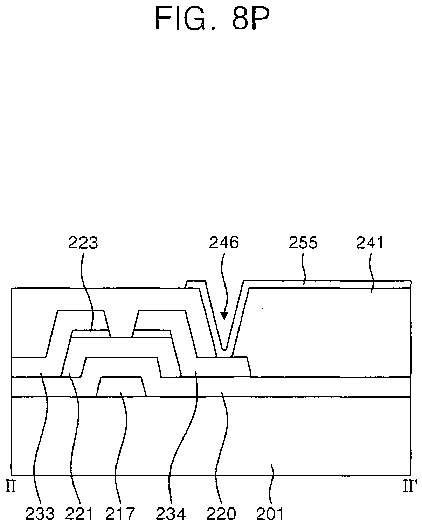

Next, as shown in FIGS. 8N and 8P, forming the first and second electrodes 251 and 252 of the gate driving circuit and the pixel electrode 255 of the pixel area on the protecting layer 241 will now be described.

The first and second connecting electrodes 251 and 252 and the pixel electrode 255 are formed of a transparent conductive material by a sputtering method, etc. on the protecting layer 241. The first and second connecting electrodes 251 and 252 and the pixel electrode 255 are formed of a transparent conductive material such as ITO (Indium Tin Oxide), IZO (Indium Zinc Oxide) or TO (Tin Oxide). The first and second connecting electrodes 251 and 252 and the pixel electrode 255 are formed by patterning the transparent conductive material by photolithographic and etching processes using a mask.

The first and second connecting electrodes 251 and 252 are connected to the second electrode 231 and the gate pad 213, and the contact portion 215 through the first to fourth contact holes 242, 243, 244, and 245. The pixel electrode 255 is connected to the drain electrode 234 through the fifth contact hole 246.

As described above, the gate driving circuit and the liquid crystal display having the same in accordance with embodiments of the present invention prevent the electrostatic discharge generated in the pixel area from introducing into the gate driving circuit by forming the gate pad and the contact portion connected to the second electrode and the connecting electrode. As a result, the present invention prevents the gate driving circuit from being damaged by the electrostatic discharge and a driving failure of the liquid crystal display.

While this invention has been described in connection with what is presently considered to be practical exemplary embodiments, it is to be understood that the invention is not limited to the disclosed embodiments.

## Claims

1. A gate driving circuit (130; 140) comprising:
a plurality of stages (STG1, ..., STG(n+1)) each stage (STG1) comprising:
a gate line (214);
a pull-up transistor (NT1) outputting a gate driving signal for driving the gate line (214);
a capacitor (210, C1) formed with a dielectric substance disposed between a first electrode (211) connected to a gate electrode (217) of the pull-up transistor (NT1) and a second electrode (231) connected to a drain electrode (233) of the pull-up transistor (NT1);
a holding transistor (NT5) connected to the pull-up transistor (NT1) to maintain a voltage level of the gate driving signal;
a switching transistor (NT8) connected to the pull-up transistor (NT1) and the capacitor (210, C1) to control the holding transistor (NT5) through the gate driving signal; and
a second connecting electrode (252) connecting the second electrode (231) to a contact portion (215), the contact portion (215) connected to a gate electrode (217) of the switching transistor (NT8);
**characterized in that**
each stage (STG1) comprises a gate pad (213) formed at one end of the gate line (214) and a first connecting electrode (251) connecting the gate pad (213) to the second electrode (231), wherein the second electrode (231) is larger than the first electrode (211) for forming a contact region for the first connecting electrode (251) and for the second connecting electrode (252);
the first electrode (211) of the capacitor (210, C1), the gate pad (213) and the contact portion (215) are disposed on an insulating substrate layer (201);
an insulating layer (220) is disposed on the substrate (201) covering the first electrode (211), the gate pad (213) and the contact portion (215), wherein the insulating layer (220) comprises contact holes (242; 243; 244; 245; 246) for contacting at least the first electrode (211), the gate pad (213) and the contact portion (215); and
the second electrode (231) is disposed on the insulating layer (220);
wherein the gate driving circuit (130; 140) further comprises a signal supply line (216) that connects the contact portion (215) to the gate electrode of the switching transistor (NT8), wherein the contact portion (215) is spaced apart from the gate pad (213) by a predetermined distance;
wherein the dielectric substance is formed by the insulating layer (220) insulating the gate line (214), and by an amorphous silicon layer.

2. The gate driving circuit (130; 140) of claim 1, wherein the contact portion (215) is spaced apart from the gate pad (213) by more than a width of the gate line (214).

3. The gate driving circuit (130; 140) of claim 2, wherein the contact portion (215) is spaced apart from the gate pad (213) by the distance (L) of more than 4µm.

4. The gate driving circuit (130; 140) of claim 2, wherein the contact portion (215) is disposed between the first electrode (211) and the gate pad (213).

5. The gate driving circuit (130; 140) of claim 2, wherein the gate pad (213) is spaced apart from the first electrode (211) by more than a width of the gate line (214).

6. A liquid crystal display comprising:
a liquid crystal display panel (110) including gate lines (GL1, ..., GLn) and data lines (DL1, ..., DLm);
a data driving circuit (120) to drive the data lines (DL1, ..., DLm); and
a gate driving circuit (130; 140) according to one of the claims 1 to 5;

7. The liquid crystal display of claim 6, further comprising:
a power supply (180) adapted to generate a voltage for driving the data and gate driving circuits (120; 130; 140) utilizing a voltage received from an external source;
a timing controller (170) generating gate and data control signals to control the gate and data lines (GL1, ..., GLn; DL1, ..., DLm); and
a level shifter (150; 160) receiving the gate and data control signals from the timing controller (170) and the gate driving voltage from the power supply (180) and generating a signal driving the gate driving circuit (130; 140).

8. The liquid crystal display of claim 6, wherein the gate driving circuit (130; 140) is formed at at least one end of the gate line (214).

9. A method of manufacturing the gate driving circuit (130; 140) of claim 1, the method comprising:
forming a plurality of stages (STG1, ..., STG(n+1)) each stage (STG1) comprising:
forming a gate line (214);
forming a pull-up transistor (NT1) outputting a gate driving signal for driving the gate line (214);
forming a capacitor (210, C1) formed with a dielectric substance disposed between a first electrode (211) connected to a gate electrode (217) of the pull-up transistor (NT1) and a second electrode (231) connected to a drain electrode (233) of the pull-up transistor (NT1);
forming a holding transistor (NT5) connected to the pull-up transistor (NT1) to maintain a voltage level of the gate driving signal;
forming a switching transistor (NT8) connected to the pull-up transistor (NT1) and the capacitor (210, C1) to control the holding transistor (NT5) through the gate driving signal; and
forming a second connecting electrode (252) connecting the second electrode (231) to a contact portion (215), the contact portion (215) connected to a gate electrode (217) of the switching transistor (NT8);
**characterized in that**
for each stage (STG1) a gate pad (213) is formed at one end of the gate line (214) and a first connecting electrode (251) connecting the gate pad (213) to the second electrode (231), wherein the second electrode (231) is larger than the first electrode (211) for forming a contact region for the first connecting electrode (251) and for the second connecting electrode (252);
the first electrode (211) of the capacitor (210, C1), the gate pad (213) and the contact portion (215) is disposed on an insulating substrate layer (201);
an insulating layer (220) is disposed on the substrate (201) covering the first electrode (211), the gate pad (213) and the contact portion (215), wherein contact holes (242; 243; 244; 245; 246) for contacting at least the first electrode (211), the gate pad (213) and the contact portion (215) are formed in the insulating layer (220); and
the second electrode (231) is disposed on the insulating layer (220);
the gate driving circuit (130; 140) is provided with a signal supply line (216) that connects the contact portion (215) to the gate electrode of the switching transistor (NT8), wherein the contact portion (215) is spaced apart from the gate pad (213) by a predetermined distance;
wherein the dielectric substance is formed by the insulating layer (220) insulating the gate line and by an amorphous silicon layer (221).

10. The method of claim 9, further comprising:
forming a gate metal pattern including the gate line (214), the gate pad (213), the first electrode (211), the contact portion (215), the signal supply line (216), and the gate electrode (217) on the substrate (201);
forming the insulating layer (220) on the gate metal layer;
forming a semiconductor layer including an active layer (221) and an ohmic contact layer (223) on the insulating layer (220);
forming a data metal pattern including the second electrode (231) and the drain electrode (233; 234) on the semiconductor layer;
forming a protecting layer (241) on the data metal layer and forming a contact hole (242; 243; 244; 245; 246) to expose the second electrode (231), the gate pad (213), the contact portion (215), and the drain electrode (233; 234); and
forming a connecting electrode (251; 252) and a pixel electrode (255) connected to the second electrode (231), the gate pad (213), the contact portion (215) and the drain electrode (233; 234) exposed through the contact hole (242; 243; 244; 245; 246).

11. the method of claim 12, wherein the forming the gate metal pattern comprises forming the gate metal pattern such that it is spaced apart from the gate pad (213) by more than a width of the gate line (214).

## Patentansprüche

1. Gate-Treiberschaltung (130, 140), umfassend:
eine Vielzahl von Stufen (STG1,..., STG(n+1)), wobei jede Stufe (STG1) umfasst:
eine Gateleitung (214);
einen Pull-up-Transistor (NT1), der ein Gate-Ansteuersignal zum Ansteuern der Gateleitung (214) ausgibt;
einen Kondensator (210, C1), der mit einem Dielektrikum gebildet ist,
angeordnet zwischen einer ersten Elektrode (211), die mit einer Gate-Elektrode (217) des Pull-up-Transistors (NT1) verbunden ist, und einer zweiten Elektrode (231), die mit einer Drain-Elektrode (233) des Pull-up-Transistors (NT1) verbunden ist;
einen Haltetransistor (NT5), der mit dem Pull-up-Transistor (NT1) verbunden ist,
um einen Spannungspegel des Gate-Ansteuersignals zu halten;
einen Schalttransistor (NT8), der mit dem Pull-up-Transistor (NT1) und dem Kondensator (210, C1) verbunden ist, um den Haltetransistor (NT5) über das Gate-Ansteuersignal zu steuern, und
eine zweite Anschlusselektrode (252), welche die zweite Elektrode (231) mit einem Kontaktabschnitt (215) verbindet, wobei der Kontaktabschnitt (215) mit einer Gate-Elektrode (217) des Schalttransistors (NT8) verbunden ist,
**dadurch gekennzeichnet, dass**
jede Stufe (STG1) eine Gate-Kontaktfläche (213), die an einem Ende der Gateleitung (214) gebildet ist, und eine erste Anschlusselektrode (251), welche die Gate-Kontaktfläche (213) mit der zweiten Elektrode (231) verbindet, umfasst,
wobei die zweite Elektrode (231) größer als die erste Elektrode (211) ist, um einen Kontaktbereich für die erste Anschlusselektrode (251) und für die zweite Anschlusselektrode (252) zu bilden;
die erste Elektrode (211) des Kondensators (210, C1), die Gate-Kontaktfläche (213) und der Kontaktabschnitt (215) auf einer isolierenden Substratschicht (201) angeordnet sind;
eine Isolierschicht (220) auf dem Substrat (201) angeordnet ist, die die erste Elektrode (211), die Gate-Kontaktfläche (213) und den Kontaktabschnitt (215) bedeckt, wobei die Isolierschicht (220) Kontaktlöcher (242; 243; 244; 245; 246) zum Kontaktieren wenigstens der ersten Elektrode (211), der Gate-Kontaktfläche (213) und des Kontaktabschnitts (215) umfasst, und
die zweite Elektrode (231) auf der Isolierschicht (220) angeordnet ist;
wobei die Gate-Treiberschaltung (130; 140) ferner eine Signalzuführleitung (216) umfasst, die den Kontaktabschnitt (215) mit der Gate-Elektrode des Schalttransistors (NT8) verbindet, wobei der Kontaktabschnitt (215) in einem vorbestimmten Abstand zur Gate-Kontaktfläche (213) angeordnet ist;
wobei die dielektrische Substanz durch die Isolierschicht (220), welche die Gateleitung (214) isoliert, und durch
eine amorphe Siliziumschicht gebildet ist.

2. Gate-Treiberschaltung (130; 140) nach Anspruch 1, wobei der Kontaktabschnitt (215) in einem Abstand von mehr als einer Breite der Gateleitung (214) zur Gate-Kontaktfläche (213) angeordnet ist.

3. Gate-Treiberschaltung (130; 140) nach Anspruch 2, wobei der Kontaktabschnitt (215) in einem Abstand (L) von mehr als 4µm zur Gate-Kontaktfläche (213) angeordnet ist.

4. Gate-Treiberschaltung (130; 140) nach Anspruch 2, wobei der Kontaktabschnitt (215) zwischen der ersten Elektrode (211) und der Gate-Kontaktfläche (213) angeordnet ist.

5. Gate-Treiberschaltung (130; 140) nach Anspruch 2, wobei die Gate-Kontaktfläche (213) in einem Abstand von mehr als einer Breite der Gateleitung (214) zur ersten Elektrode (211) angeordnet ist.

6. Flüssigkristallanzeige, umfassend:
ein Flüssigkristallanzeigepanel (110) mit Gateleitungen (GL1,..., GLn) und
Datenleitungen (DL1,..., DLm);
eine Datentreiberschaltung (120) zum Ansteuern der Datenleitungen (DL1, ..., DLm), und
eine Gate-Treiberschaltung (130; 140) nach einem der Ansprüche 1 bis 5.

7. Flüssigkristallanzeige nach Anspruch 6, ferner umfassend:
eine Stromversorgung (180), die dazu eingerichtet ist, eine Spannung zum Ansteuern der Daten- und Gate-Treiberschaltungen (120; 130; 140) mittels einer von einer externen Quelle empfangenen Spannung zu erzeugen;
eine Zeitsteuereinrichtung (170), die Gate- und Daten-Steuersignale zur Steuerung der Gate- und Datenleitungen (GL1, ..., GLn; DL1, ..., DLm) erzeugt, und
einen Pegelschieber (150; 160), der die Gate- und Daten-Steuersignale von der Zeitsteuereinrichtung (170) und die Gate-Ansteuerspannung von der Stromversorgung (180) empfängt und ein Signal zum Ansteuern der Gate-Treiberschaltung (130; 140) erzeugt.

8. Flüssigkristallanzeige nach Anspruch 6, wobei die Gate-Treiberschaltung (130; 140) an wenigstens einem Ende der Gateleitung (214) gebildet ist.

9. Verfahren zur Herstellung der Gate-Treiberschaltung (130; 140) nach Anspruch 1, wobei das Verfahren umfasst:
Bilden einer Vielzahl von Stufen (STG1,..., STG(n+1)), wobei jede Stufe (STG1) umfasst:
Bilden einer Gateleitung (214);
Bilden eines Pull-up-Transistors (NT1), der ein Gate-Ansteuersignal zum Ansteuern der Gateleitung (214) ausgibt;
Bilden eines Kondensators (210, C1), der mit einer dielektrischen Substanz gebildet ist, angeordnet zwischen einer ersten Elektrode (211), die mit einer Gate-Elektrode (217) des Pull-up-Transistors (NT1) verbunden ist, und einer zweiten Elektrode (231), die mit einer Drain-Elektrode (233) des Pull-up-Transistors (NT1) verbunden ist;
Bilden eines Haltetransistors (NT5), der mit dem Pull-up-Transistor (NT1) verbunden ist, um einen Spannungspegel des Gate-Ansteuersignals zu halten;
Bilden eines Schalttransistors (NT8), der mit dem Pull-up-Transistor (NT1) und dem Kondensator (210, C1) verbunden ist, um den Haltetransistor (NT5) über das Gate-Ansteuersignal zu steuern, und
Bilden einer zweiten Anschlusselektrode (252), welche die zweite Elektrode (231) mit einem Kontaktabschnitt (215) verbindet, wobei der Kontaktabschnitt (215) mit einer Gate-Elektrode (217) des Schalttransistors (NT8) verbunden ist,
**dadurch gekennzeichnet, dass**
für jede Stufe (STG1) eine Gate-Kontaktfläche (213) an einem Ende der Gateleitung (214) gebildet ist und eine erste Anschlusselektrode (251) die Gate-Kontaktfläche (213) mit der zweiten Elektrode (231) verbindet, wobei die zweite Elektrode (231) größer als die erste Elektrode (211) ist, um einen Kontaktbereich für die erste Anschlusselektrode (251) und für die zweite Anschlusselektrode (252) zu bilden;
die erste Elektrode (211) des Kondensators (210, C1), die Gate-Kontaktfläche (213) und der Kontaktabschnitt (215) auf einer isolierenden Substratschicht (201) angeordnet sind;
eine Isolierschicht (220) auf dem Substrat (201) angeordnet ist, die die erste Elektrode (211), die Gate-Kontaktfläche (213) und den Kontaktabschnitt (215) bedeckt, wobei in der Isolierschicht (220) Kontaktlöcher (242; 243; 244; 245; 246) zum Kontaktieren wenigstens der ersten Elektrode (211), der Gate-Kontaktfläche (213) und des Kontaktabschnitts (215) gebildet sind, und die zweite Elektrode (231) auf der Isolierschicht (220) angeordnet ist;
wobei die Gate-Treiberschaltung (130; 140) mit einer Signalzuführleitung (216) versehen ist, die den Kontaktabschnitt (215) mit der Gate-Elektrode des Schalttransistors (NT8) verbindet, wobei der Kontaktabschnitt (215) in einem vorbestimmten Abstand zur Gate-Kontaktfläche (213) angeordnet ist;
wobei die dielektrische Substanz durch die Isolierschicht (220), welche die Gateleitung isoliert, und durch eine amorphe Siliziumschicht (221) gebildet ist.

10. Verfahren nach Anspruch 9, das ferner die Schritte umfasst:
Bilden einer Gate-Metallstruktur, umfassend die Gateleitung (214), die Gate-Kontaktfläche (213), die erste Elektrode (211), den Kontaktabschnitt (215), die Signalzuführleitung (216) und die Gate-Elektrode (217) auf dem Substrat (201);
Bilden der Isolierschicht (220) auf der Gate-Metallschicht;
Bilden einer Halbleiterschicht mit einer aktiven Schicht (221) und einer ohmschen Kontaktschicht (223) auf der Isolierschicht (220);
Bilden einer Daten-Metallstruktur, enthaltend die zweite Elektrode (231) und die Drain-Elektrode (233; 234), auf der Halbleiterschicht;
Bilden einer Schutzschicht (241) auf der Daten-Metallstruktur und Bilden eines Kontaktlochs (242; 243; 244; 245; 246), um die zweite Elektrode (231), die Gate-Kontaktfläche (213), den Kontaktabschnitt (215) und die Drain-Elektrode (233; 234) freizulegen, und
Bilden einer Anschlusselektrode (251; 252) und einer Pixelelektrode (255), die mit der zweiten Elektrode (231), der Gate-Kontaktfläche (213), dem Kontaktabschnitt (215) und der Drain-Elektrode (233; 234), welche durch das Kontaktloch (242; 243; 244; 245; 246) freigelegt sind, verbunden sind.

11. Verfahren nach Anspruch 12, wobei das Bilden der Gate-Metallstruktur umfasst, dass diese so gebildet wird, dass sie in einem Abstand von mehr als einer Breite der Gateleitung (214) zur Gate-Kontaktfläche (213) angeordnet ist.

## Revendications

1. Circuit d'attaque de grille (130 ; 140) comprenant :
une pluralité d'étages (STG1, ..., STG(n+1)), chaque étage (STG1) comprenant :
une ligne de grille (214) ;
un transistor de tirage vers le haut (NT1) délivrant un signal d'attaque de grille pour attaquer la ligne de grille (214) ;
un condensateur (210, C1) formé avec une substance diélectrique disposée entre une première électrode (211) connectée à une électrode de grille (217) du transistor de tirage vers le haut (NT1) et une seconde électrode (231) connectée à une électrode de drain (233) du transistor de tirage vers le haut (NT1) ;
un transistor de maintien (NT5) connecté au transistor de tirage vers le haut (NT1) pour maintenir un niveau de tension du signal d'attaque de grille ;
un transistor de commutation (NT8) connecté au transistor de tirage vers le haut (NT1) et au condensateur (210, C1) pour commander le transistor de maintien (NT5) par l'intermédiaire du signal d'attaque de grille ; et
une seconde électrode de connexion (252) connectant la seconde électrode (231) à une partie de contact (215), la partie de contact (215) étant connectée à une électrode de grille (217) du transistor de commutation (NT8) ;
**caractérisé en ce que**
chaque étage (STG1) comprend un plot de grille (213) formé à une extrémité de la ligne de grille (214) et une première électrode de connexion (251) connectant le plot de grille (213) à la seconde électrode (231), la seconde électrode (231) étant plus grande que la première électrode (211) pour former une région de contact pour la première électrode de connexion (251) et pour la seconde électrode de connexion (252) ;
la première électrode (211) du condensateur (210, C1), le plot de grille (213) et la partie de contact (215) sont disposés sur une couche de substrat isolant (201) ;
une couche isolante (220) est disposée sur le substrat (201) couvrant la première électrode (211), le plot de grille (213) et la partie de contact (215), la couche isolante (220) comprenant des trous de contact (242 ; 243 ; 244 ; 245 ; 246) pour la mise en contact avec au moins la première électrode (211), le plot de grille (213) et la partie de contact (215) ; et
la seconde électrode (231) est disposée sur la couche isolante (220) ;
lequel circuit d'attaque de grille (130; 140) comprend en outre une ligne d'amenée de signaux (216) qui connecte la partie de contact (215) à l'électrode de grille du transistor de commutation (NT8), la partie de contact (215) étant espacée du plot de grille (213) d'une distance prédéterminée ;
la substance diélectrique étant formée par la couche isolante (220) qui isole la ligne de grille (214) et par une couche de silicium amorphe.

2. Circuit d'attaque de grille (130 ; 140) selon la revendication 1, dans lequel la partie de contact (215) est espacée du plot de grille (213) de plus d'une largeur de la ligne de grille (214).

3. Circuit d'attaque de grille (130 ; 140) selon la revendication 2, dans lequel la partie de contact (215) est espacée du plot de grille (213) d'une distance (L) supérieure à 4 µm.

4. Circuit d'attaque de grille (130 ; 140) selon la revendication 2, dans lequel la partie de contact (215) est disposée entre la première électrode (211) et le plot de grille (213).

5. Circuit d'attaque de grille (130 ; 140) selon la revendication 2, dans lequel le plot de grille (213) est espacé de la première électrode (211) de plus d'une largeur de la ligne de grille (214).

6. Afficheur à cristaux liquides comprenant :
un panneau d'affichage à cristaux liquides (110) incluant des lignes de grille (GL1, ..., GLn) et des lignes de données (DL1, ..., DLm) ;
un circuit d'attaque de données (120) pour attaquer les lignes de données (DL1, ..., DLm) ; et
un circuit d'attaque de grille (130 ; 140) selon l'une des revendications 1 à 5.

7. Afficheur à cristaux liquides selon la revendication 6, comprenant en outre :
une alimentation électrique (180) adaptée à générer une tension pour attaquer les circuits d'attaque de données et de grille (120 ; 130 ; 140) en utilisant une tension reçue d'une source externe ;
un dispositif de commande de synchronisation (170) générant des signaux de commande de grille et de données pour commander les lignes de grille et de données (GL1, ..., GLn ; DL1, ..., DLm) ; et
un translateur de niveau (150 ; 160) recevant les signaux de commande de grille et de données du dispositif de commande de synchronisation (170) et la tension d'attaque de grille de l'alimentation électrique (180) et générant un signal attaquant le circuit d'attaque de grille (130 ; 140).

8. Afficheur à cristaux liquides selon la revendication 6, dans lequel le circuit d'attaque de grille (130 ; 140) est formée à au moins une extrémité de la ligne de grille (214).

9. Procédé de fabrication du circuit d'attaque de grille (130; 140) selon la revendication 1, consistant à :
former une pluralité d'étages (STG1, ..., STG(n+1)), chaque étage (STG1) consistant à :
former une ligne de grille (214) ;
former un transistor de tirage vers le haut (NT1) délivrant un signal d'attaque de grille pour attaquer la ligne de grille (214) ;
former un condensateur (210, C1) formé avec une substance diélectrique disposée entre une première électrode (211) connectée à une électrode de grille (217) du transistor de tirage vers le haut (NT1) et une seconde électrode (231) connectée à une électrode de drain (233) du transistor de tirage vers le haut (NT1) ;
former un transistor de maintien (NT5) connecté au transistor de tirage vers le haut (NT1) pour maintenir un niveau de tension du signal d'attaque de grille ;
former un transistor de commutation (NT8) connecté au transistor de tirage vers le haut (NT1) et au condensateur (210, C1) pour commander le transistor de maintien (NT5) par l'intermédiaire du signal d'attaque de grille ; et
former une seconde électrode de connexion (252) connectant la seconde électrode (231) à une partie de contact (215), la partie de contact (215) étant connectée à une électrode de grille (217) du transistor de commutation (NT8) ;
**caractérisé en ce que**
pour chaque étage (STG1), un plot de grille (213) est formé à une extrémité de la ligne de grille (214) et une première électrode de connexion (251) connecte le plot de grille (213) à la seconde électrode (231), la seconde électrode (231) étant plus grande que la première électrode (211) pour former une région de contact pour la première électrode de connexion (251) et pour la seconde électrode de connexion (252) ;
la première électrode (211) du condensateur (210, C1), le plot de grille (213) et la partie de contact (215) sont disposés sur une couche de substrat isolant (201) ;
une couche isolante (220) est disposée sur le substrat (201) couvrant la première électrode (211), le plot de grille (213) et la partie de contact (215), des trous de contact (242 ; 243 ; 244 ; 245 ; 246) pour la mise en contact avec au moins la première électrode (211), le plot de grille (213) et la partie de contact (215) étant formés dans la couche isolante (220) ; et
la seconde électrode (231) est disposée sur la couche isolante (220) ;
lequel circuit d'attaque de grille (130 ; 140) est pourvu d'une ligne d'amenée de signaux (216) qui connecte la partie de contact (215) à l'électrode de grille du transistor de commutation (NT8), la partie de contact (215) étant espacée du plot de grille (213) d'une distance prédéterminée ;
la substance diélectrique étant formée par la couche isolante (220) qui isole la ligne de grille et par une couche de silicium amorphe.

10. Procédé selon la revendication 9, consistant en outre à :
former un motif métallique de grille incluant la ligne de grille (214), le plot de grille (213), la première électrode (211), la partie de contact (215), la ligne d'amenée de signaux (216) et l'électrode de grille (217) sur le substrat (201) ;
former la couche isolante (220) sur la couche métallique de grille ;
former une couche semi-conductrice incluant une couche active (221) et une couche de contact ohmique (223) sur la couche isolante (220) ;
former un motif métallique de données incluant la seconde électrode (231) et l'électrode de drain (233 ; 234) sur la couche semi-conductrice ;
former une couche protectrice (241) sur la couche métallique de données et former un trou de contact (242 ; 243 ; 244 ; 245 ; 246) pour exposer la seconde électrode (231), le plot de grille (213), la partie de contact (215) et l'électrode de drain (233 ; 234) ; et
former une électrode de connexion (251 ; 252) et une électrode de pixel (255) connectées à la seconde électrode (231), au plot de grille (213), à la partie de contact (215) et à l'électrode de drain (233 ; 234) exposés à travers le trou de contact (242 ; 243 ; 244 ; 245 ; 246).

11. Procédé selon la revendication 12, dans lequel former le motif métallique de grille consiste à former le motif métallique de grille de telle sorte qu'il soit espacé du plot de grille (213) de plus d'une largeur de la ligne de grille (214).
